# EUROPÄISCHE PATENTSCHRIFT

(11) **EP 1 003 035 B1**
(45) Veröffentlichungstag und Bekanntmachung des Hinweises auf die Patenterteilung: **10.05.2006**
(21) Anmeldenummer: 99122523.6
(22) Anmeldetag: 12.11.1999
(51) Int. Cl.: G01N 27/414

(54) **Messeinrichtung**
Measuring device
Dispositif de mesure

(30) Priorität: 17.11.1998 DE 19852967
(43) Veröffentlichungstag der Anmeldung: 24.05.2000
(73) Patentinhaber: Micronas GmbH, 79108 Freiburg i. Br. (DE)
(72) Erfinder: Igel, Günter Dipl.-Ing., 79331 Teningen (DE); Sieben, Ulrich Dr.Dipl.-Phys., 79276 Reute (DE); Giehl, Jürgen Dr.Dipl.-Phys., 79199 Kirchzarten (DE); Wolf, Bernhard Prof.Dr., 18057 Rostock (DE)
(74) Vertreter: Huwer, Andreas

(56) Entgegenhaltungen:
- EP-A- 0 172 669
- WO-A-98/05935
- DE-A- 19 810 060
- DE-A- 19 814 857
- J.H. LAU: "Flip Chip Technologies" 1995 , MC GRAW-HILL XP002148418 * Seite 260-261; Abbildung 6.26 *

## Beschreibung

Die Erfindung betrifft eine Meßeinrichtung mit wenigstens einer Halbleiteranordnung, die einen eine Vorder- und eine Rückseite aufweisenden Halbleiterchip und ein mit diesem verbundenes, zumindest ein Durchgangsloch aufweisendes Trägerteil umfaßt, wobei der Halbleiterchip wenigstens einen Sensor mit einer aktiven Sensorfläche aufweist, die an der Vorderseite des Halbleiterchips angeordnet und dem Durchgangsloch zugewandt ist, wobei der Halbleiterchip elektrische Anschlußstellen hat, die mittels Flip-Chip-Verbindungen mit an dem Trägerteil befindlichen, den Anschlußstellen zugewandten Anschlußkontakten verbunden sind, wobei das Trägerteil elektrische Leiterbahnen aufweist, welche die Anschlußkontakte mit an einer Rückseite des Trägerteils befindlichen Kontaktelementen verbinden, wobei wenigstens ein Leiterbahnträger vorgesehen ist, der mit den Kontaktelementen verbundene, an Leiterbahnen angeschlossene Gegenkontakte aufweist, wobei zwischen dem Trägerteil und dem Halbleiterchip eine Dichtung angeordnet ist, die das Durchgangsloch gegen die Rückseite des Halbleiterchips abdichtet, wobei der Halbleiterchip, die Dichtung und das Trägerteil eine Meßkammer begrenzen.

Eine solche Meßeinrichtung ist aus John H. Lau, Flip Chip Technologies, McGraw-Hill (1995), Seite 260 und 261 bekannt. Dabei ist das Durchgangsloch an einem seiner Axialenden von dem Halbleiterchip und an seinem anderen Axialende von dem Leiterbahnträger überdeckt. In dem Überdeckungsbereich weist der Leiterbahnträger mit Zu- und Abführkanälen verbundene Öffnungen für ein zu untersuchendes, durch die Meßkammer hindurchgeleitetes Fluid auf. An der dem Halbleiterchip abgewandten Rückseite des Trägerteils ist der Leiterbahnträger durch eine Klebeschicht mit den das Durchgangsloch umgrenzenden Randbereich des Trägerteils verbunden. Zwischen dem Halbleiterchip und dem Trägerteil ist ein Spalt gebildet, indem Polymer-Bumps angeordnet sind, welche die Anschlußstelle des Halbleiterchips mit den ihnen jeweils zugeordneten Anschlußkontakten des Trägerteils verbinden. Zwischen der aktiven Sensorfläche und den Polymer-Bumps ist als Dichtung ein Dichtring angeordnet, welche das in der Messkammer bzw. dem Probenraum befindliche Fluid gegen die Polymer-Bumps und die der aktiven Sensorfläche abgewandte Rückseite des Halbleiterchips abdichtet. Der Dichtring weist an seinen Flachseiten jeweils eine Dichtfläche auf, von denen die eine an dem Halbleiterchip und die andere an dem Trägerteil anliegt.

Derartige Meßeinrichtungen werden beispielsweise für chemische und/oder biolgische Untersuchungen eines in der Meßkammer befindlichen Mediums verwendet. Dabei ist es bei bestimmten Untersuchungen erforderlich, während der Messung zwei unterschiedliche Substanzen gleichzeitig, jedoch getrennt voneinander in das Durchgangsloch einzubringen und dem Sensor zuzuführen, beispielsweise wenn diese Substanzen chemisch miteinander reagieren und diese chemische Reaktion mittels des Sensors überwacht werden soll. Bei der vorbekannten Vorrichtung können jedoch unterschiedlicher Substanzen in dem Fluidstrom nur gemeinsam zugeführt werden, d.h. die Substanzen müssen bereits außerhalb der Meßkammer miteinander in Berührung gebracht werden.

Aus DE 198 10 060 A1 ist ferner eine gattungsfremde Meßeinrichtungbekannt, die einen Halbleiterchip und ein damit verbundenes, ein Durchgangsloch aufweisendes Trägerteil hat. Zwischen dem Trägerteil und dem Halbleiterchip ist eine Flip-Chip-Verbindung vorgesehen, die von einem Unterfüller umgrenzt ist, der ringförmig um das Durchgangsloch herum angeordnet ist und den Halbleiterchip dicht mit dem Trägerteil verbindet. Ein Leiterbahnträger, der mit den Kontaktelementen verbundene, an Leiterbahnen angeschlossene Gegenkontakte aufweist, ist in dieser Druckschrift nicht offenbart. Der Halbleiterchip ist als aktives Bauelement ausgebildet, das eine Substanz durch Aufheizen freisetzt. Zusätzlich kann eine weitere Substanz durch eine an dem von dem Halbleiterchip entfernten Ende des Durchgangslochsvorgesehene, mit einer teildurchlässigen Membran abgedeckten Öffnung hindurch in das Durchgangsloch eingebracht werden. Die Meßeinrichtung hat jedoch den Nachteil, daß zusätzlich zu der für den Sensor benötigten Chipfläche auf dem Halbleiterchip noch Platz für die Unterbringung der freizusetzenden Substanz und ggf. der Heizung zum Aufheizen dieser Substanz vorgesehen sein muß. Da die Kosten für die Herstellung eines Halbleiterchips mit zunehmender Größe der Chipfläche überproportional ansteigen, ist die Meßeinrichtung noch vergleichsweise teuer. Auch müssen bei der Wahl der freizusetzenden Substanz gewisse Einschränkungen in Kauf genommen werden, da nicht alle Substanzen eine Freisetzung bei Erwärmung ermöglichen. Schließlich kann aber auch das Meßergebnis durch die Wärmeeinbringung beeinflußt werden.

Auch aus WO 98/05935 A1 ist eine gattungsfremde Meßeinrichtung bekannt, die einen Halbleiterchip und ein damit verbundenes, ein Durchgangsloch aufweisendes Trägerteil hat. Der Halbleiterchip hat einen z.B. druckempfindlichen Sensor, der mit seiner aktiven Sensorfläche dem Durchgangsloch zugewandt ist. An seinem gegenüberliegenden, von der Sensorfläche entfernten Ende hat das Durchgangsloch eine Öffnung, die mit einer dünnen, porösen Schicht abgedeckt ist. Der Halbleiterchip ist durch einen Zwischenraum von dem Trägerteil beabstandet, in dem eine Flip-Chip-Verbindung angeordnet ist. Die Flip-Chip-Verbindung ist von einem Unterfüller, z.B. einem Epoxyharz, umgeben, der den Halbleiterchip dicht mit dem Trägerteil verbindet. Das Durchgangsloch ist also nur durch die poröse Schicht hindurch von außen zugänglich. Auch dieser Vorrichtung fehlt es an einem Leiterbahnträger, der mit den Kontaktelementen verbundene, an Leiterbahnen angeschlossene Gegenkontakte aufweist.

Der Erfindung liegt die Erfindung zu Grunde, eine Meßeinrichtung der eingangs genannten Art zu schaffen, die einen kompakten Aufbau ermöglicht und die voneinander unabhängige Zugänge zu der Meßkammer aufweist.

Die Lösung dieser Aufgabe besteht darin, daß zumindest ein Teilbereich des Leiterbahnträgers an der Rückseite des Trägerteils mit den Gegenkontakten den Kontaktelementen des Trägerteils zugewandt angeordnet ist, daß die Gegenkontakte des Leiterbahnträgers mit den ihnen jeweils zugeordneten Kontaktelementen des Trägerteils mittels Flip-Chip-Verbindungen verbunden sind, und dass die Dichtung zum Einbringen einer Substanz in die Meßkammer zumindest bereichsweise porös oder halbporös ausgebildet ist.

Durch die Dichtung hindurch kann dann beispielsweise ein Wirkstoff in den durch das Durchgangsloch des Trägerteils gebildeten Probenraum eingebracht werden, beispielsweise um die Wirkung des Wirkstoffs auf dort befindliche biologische Zellen mit dem Sensor des Halbleiterchips zu untersuchen. An der dem Durchgangsloch abgewandten Rückseite der Dichtung kann beispielsweise ein Depot für den Wirkstoff oder dergleichen in das Durchgangsloch einzubringende Substanz angeordnet sein und/oder die Dichtung ist rückseitig mit einem Zuführkanal für die Substanz verbunden. Gegebenenfalls kann die poröse oder halbporöse Dichtung auch als Filter für ein in das Durchgangsloch einzubringendes Medium dienen.

Die vorstehend genannte Aufgabe kann auch dadurch gelöst werden, daß zumindest ein Teilbereich des Leiterbahnträgers an der Rückseite des Trägerteils mit den Gegenkontakten den Kontaktelementen des Trägerteils zugewandt angeordnet ist, daß die Gegenkontakte des Leiterbahnträgers mit den ihnen jeweils zugeordneten Kontaktelementen des Trägerteils mittels Flip-Chip-Verbindungen verbunden sind, und daß die Dichtung zum Einbringen einer Substanz in die Meßkammer als Membrane ausgebildet ist.

Dadurch ist es möglich, nur bestimmten chemischen Stoffen, die durch die Membran diffundieren können, den Durchtritt durch den Spalt zu ermöglichen und andere Stoffe am Durchtritt durch den Spalt zu hindern. Dabei ermöglicht die Membran ein Abdichten des an der Vorderseite des Halbleiterchips befindlichen Durchgangslochs gegen die Rückseite des Halbleiterchips. Durch die Membran können beispielsweise in dem Durchgangsloch befindlichen, in einem Nährmedium oder einem osmotischen Schutzmedium angeordneten biologischen Komponenten bestimmte Wirkstoffe zugeführt werden, um die Reaktion der biologischen Komponenten mittels des Halbleiterchip-Sensors zu untersuchen. Die Membran kann beispielsweise aus für Wasserstoff durchlässigem Polyäthylen oder aus Polyvinylchlorid bestehen. Es kann aber auch eine Membran aus für Fluor durchlässigem Lanthanfluorid oder aus einem anderen Material vorgesehen sein. Die in dem Spalt angeordnete Membran kann eine richtungsabhängige Durchlässigkeit aufweisen.

Die Dichtung kann als Formdichtung ausgebildet sein, die ein oder mehrere, bestimmte Bereiche des Halbleiterchips freilassende Fenster aufweist. Auch kann die Dichtung über die Oberflächenebene der das Durchgangsloch umgrenzenden Wandung des Trägerteils nach innen vorstehen und bereichsweise den Querschnitt des Durchgangslochs überdecken. Der über den Rand des Trägerteil-Durchgangslochs nach innen vorstehende Bereich der Dichtung kann dann als Auflage für ein in dem Durchgangsloch befindliches oder in dieses einsetzbares Anschlußteil dienen. Das Anschlußteil kann Ein- und/oder Austrittsöffnungen für das zu untersuchende Medium aufweisen und gegebenenfalls Teil eines Pumpengehäuses sein.

Eine Ausführungsform der Erfindung sieht vor, daß die Dichtung durch eine in den zwischen dem Halbleiterchip und dem Trägerteil befindlichen Spalt eingefüllte Vergußmasse gebildet ist. Diese ermöglicht eine mechanisch stabile Verbindung zwischen dem Halbleiterchip und dem Trägerteil. So können beispielsweise bei einem Überdruck eines in dem Durchgangsloch befindlichen Mediums die an dem Halbleiterchip angreifenden Druckkräfte über die an dem Umfangsrand des Halbleiterchips angeordnete Vergußmasse großflächig auf das Trägerteil übertragen werden. Insbesondere wird dadurch auch die mechanische Belastung an den Flip-Chip-Verbindungen reduziert.

Vorteilhaft ist, wenn die Dichtung optisch transparent ist und/oder von mindestens einem Lichtleiter durchsetzt ist. Dadurch ist es möglich, den durch das Durchgangsloch gebildeten Probenraum durch die Dichtung hindurch zu beleuchten, so daß ein darin befindliches Medium optisch beobachtet werden kann. Durch die Dichtung und/oder den Lichtleiter können aber auch Lichtsignale aus dem Probenraum nach außen geleitet werden, beispielsweise bei Fluoreszenz einer in dem Durchgangsloch befindlichen Probe.

Eine andere Ausführungsform der Erfindung sieht vor, daß der Sensor ein optischer, insbesondere bildgebender Sensor ist, und daß in dem Durchgangsloch wenigstens eine optische Linse und/oder mindestens ein optischer Filter angeordnet ist. Der Filter und/oder die Linse können bei der Fertigung der Meßeinrichtung durch Auftropfen eines optisch durchlässigen Materials auf den Halbleiterchip oder eine auf diesem befindliche Schicht hergestellt werden. Das optisch durchlässige Material kann dann gegebenenfalls anschließend getrocknet oder durch eine chemische Reaktion ausgehärtet werden. Der Halbleiterchip und/oder das Trägerteil kann eine Auswertevorrichtung, eine Speichereinheit zum Speichern der Bilddaten und/oder ein Schnittstellenbaustein für die Übertragung der Bilddaten zu einem außerhalb der Meßeinrichtung befindlichen Anzeige- und/oder Speichergerät aufweisen. Insgesamt ergibt sich dadurch eine kostengünstig herstellbare, kompakt aufgebaute Kamera. Dabei ist es sogar möglich, daß das Trägerteil als Chipkarte ausgebildet ist.

Eine besonders vorteilhafte Ausführungsform der Erfindung sieht vor, daß das Trägerteil eine Vielzahl von Durchgangslöchern mit jeweils dort angeordnetem Halbleiterchip aufweist. Die einzelnen Halbleiterchips können dann beispielsweise chemische Sensoren aufweisen, so daß in einem Labor eine Vielzahl von Proben gleichzeitig untersucht werden können. Dabei ist es sogar möglich, daß an den einzelnen Durchgangslöchern unterschiedliche Halbleiterchips angeordnet sind und daß diese insbesondere unterschiedliche Sensoren aufweisen. Somit können eine oder mehrere unterschiedliche Proben gleichzeitig auf verschiedene chemische Eigenschaften untersucht werden.

Vorteilhaft ist, wenn an der dem Halbleiterchip abgewandten Seite des Trägerteils an dem das Durchgangsloch umgrenzenden Randbereich des Trägerteils eine Auflage für ein Formwerkzeug zum Formen eines Behältnisses angeordnet ist und wenn auf den die Auflage umgrenzenden Bereich des Trägerteils ein die Wandung des Behältnisses bildender Kunststoff aufgespritzt ist. Das Formwerkzeug kann dann bei der Herstellung des Behältnisses auf das Trägerteil aufgesetzt werden, so daß es von dem dahinter befindlichen Halbleiterchip beabstandet ist. Eine Beschädigung der empfindlichen Sensorfläche durch das Formwerkzeug wird dadurch vermieden. Außerdem wird an der Auflage eine dichte Verbindung zwischen dem Formwerkzeug und dem Trägerteil erreicht, so daß beim Umspritzen des Formwerkzeugs mit Kunststoff der Kunststoff nicht mit der aktiven Sensorfläche in Berührung geraten kann. Das Behältnis bildet zusammen mit dem Durchgangsloch des Trägerteils eine Aufnahme, die gegebenenfalls ein definiertes Volumen aufweisen kann, in das eine mit dem Sensor zu untersuchende Probe eingebracht werden kann.

Eine besonders vorteilhafte Ausführungsform sieht vor, daß die Meßeinrichtung als Mikrotiter-Meßeinrichtung mit einer Vielzahl von Halbleiteranordnungen ausgebildet ist. Dabei sind die Trägerteile der einzelnen Halbleiteranordnungen zweckmäßigerweise jeweils an ihrer dem Halbleiterchip abgewandten Vorderseite insbesondere mittels einer Klebeschicht mit einem Mikrotiterplatten-Oberteil verbunden. Dabei können die Trägerteile der einzelnen Halbleiteranordnungen gegebenenfalls auch einstückig miteinander verbunden sein. Als Mikrotiterplatten-Oberteil kann gegebenenfalls eine im Handel verfügbare Standard-Mikrotiterplatte vorgesehen sein. Zum Befüllen der einzelnen Proben-Behältnisse der Mikrotiter-Meßeinrichtung können dann in Laboratorien bereits vorhandene Beprobungseinrichtungen verwendet werden.

Erwähnt werden soll noch, daß zusätzlich zu dem Sensor des Halbleiterchips gegebenenfalls auch an dem Trägerteil wenigstens ein Sensor vorgesehen sein kann, z.B. ein ionenselektiver Feldeffekttransistor und/oder eine Elektrode. Das Trägerteil kann aber auch eine Behandlungseinrichtung für in das Durchgangsloch einzubringende Biokomponenten oder dergleichen Proben aufweisen, die beispielsweise eine Heizung und/oder eine Kühlvorrichtung umfassen kann. Ferner kann das Trägerteil einen Sender und/oder Empfänger für eine Datenübertragung zu einer externen Steuer- und/oder Auswertereinrichtung aufweisen.

Das Trägerteil kann Kontaktelemente aufweisen, welche mittels der an dem Trägerteil befindlichen Leiterbahnen mit den Anschlußkontakten des Trägerteils verbunden sind, wobei das Trägerteil zum Verändern der Lage der Kontaktelemente relativ zu den Anschlußkontakten zumindest bereichsweise aus einem flexiblen oder plastisch verformbaren Material besteht. Die Kontaktelemente können dann mit dazu passenden Anschlüssen einer Auswerteeinrichtung und/oder einer Stromversorgungseinheit verbunden werden, wobei die Lage der Kontaktelemente durch Verformen des Trägerteils an die jeweiligen örtlichen Gegebenheiten am Einbauort der Halbleiteranordnung angepaßt werden können. So ist es beispielsweise möglich, durch Biegen des Trägerteils die Anschlußkontakte gegenüber der Chipebene gegenüber des Halbleiterchips zu verschwenken, so daß die Anschlußkontakte je nach Situation am Montageort entweder an der Vorderseite des Halbleiterchips, seitlich des Halbleiterchips und/oder an dessen Rückseite angeordnet werden können.

Nachfolgend sind Ausführungsbeispiele der Erfindung anhand der Zeichnung näher erläutert. Es zeigen:
- Fig. 1: einen Querschnitt durch eine Halbleiteranordnung, mit einem ein Durchgangsloch aufweisenden Trägerteil und einem das Durchgangsloch überdeckenden Halbleiterchip,
- Fig. 2: eine Meßeinrichtung mit der in Fig. 1 gezeigten Halbleiteranordnung, wobei an der dem Halbleiterchip zugewandten Rückseite des Trägerteils ein Leiterbahnträger und an der Vorderseite des Halbleiterchips ein Behältnis zur Aufnahme einer Probe angeordnet ist,
- Fig. 3: eine Darstellung ähnlich Fig. 1, wobei jedoch in dem zwischen dem Halbleiterchip und dem Trägerteil gebildeten Spalt eine Vergußmasse angeordnet ist,
- Fig. 4: eine Darstellung ähnlich Fig. 2, wobei jedoch in den zwischen dem Halbleiterchip und dem Trägerteil eine Vergußmasse angeordnet ist,

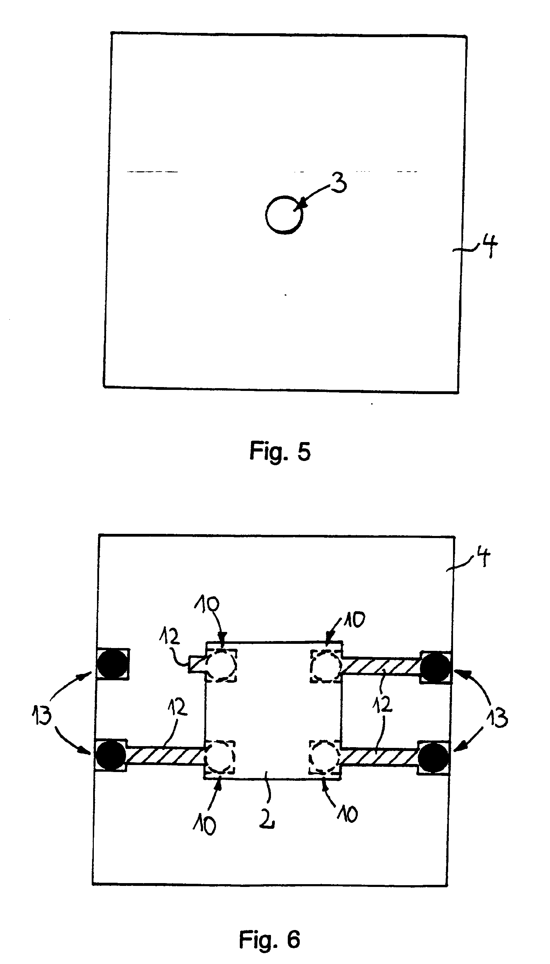

- Fig. 5: eine Aufsicht auf die Halbleiteranordnung gem. Fig. 1 und 3 und
- Fig. 6: eine Unteransicht der Halbleiteranordnung nach Fig. 1 und 3.

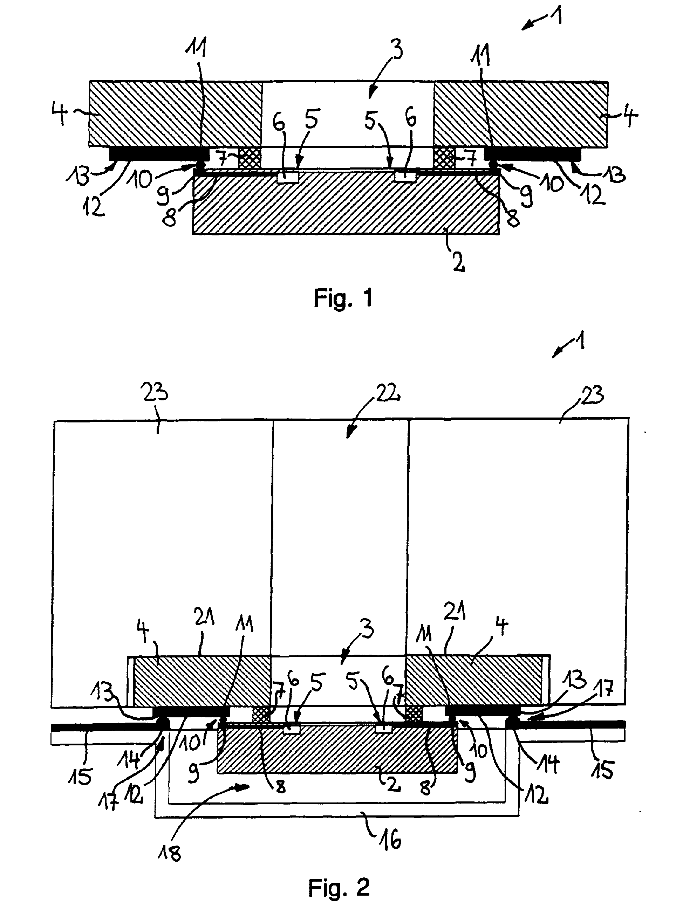

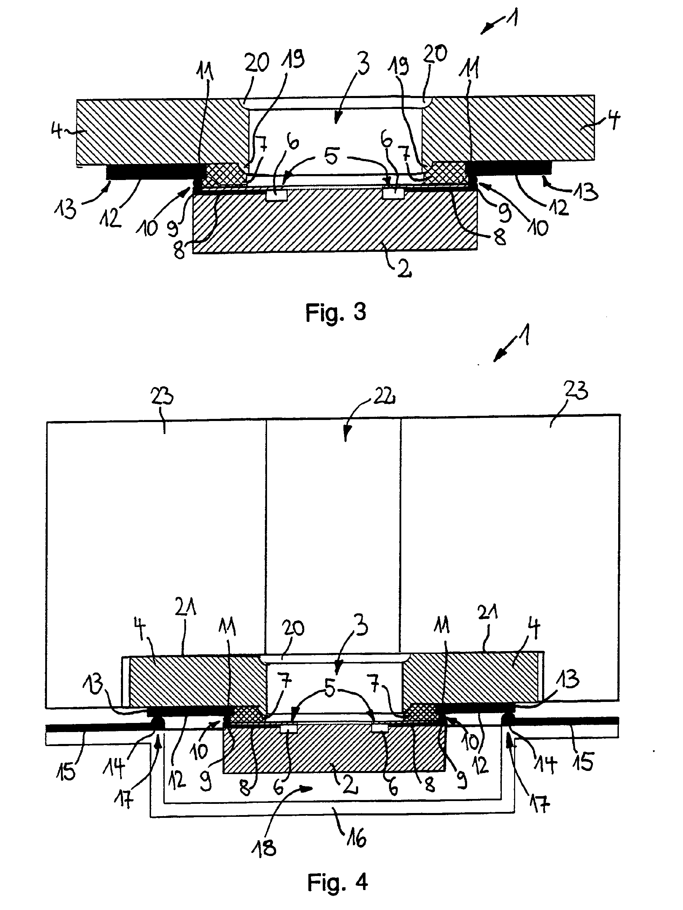

Eine im ganzen mit 1 bezeichnete Meßeinrichtung weist eine Halbleiteranordnung auf, die einen Halbleiterchip 2 und ein damit verbundenes, ein Durchgangsloch 3 aufweisendes Trägerteil 4 hat. Wie aus Fig. 2 und 4 erkennbar ist, ist das Trägerteil 4 im wesentlichen platten- oder scheibenförmig ausgebildet und weist an seinen einander abgewandten Flachseiten jeweils eine durch das Durchgangsloch 3 gebildete Öffnung auf.

Der Halbleiterchip 2 weist an einer aktiven Sensorfläche 5 mehrere Sensoren 6 auf. Diese können beispielsweise ionenselektive Feldeffekttransistoren, Interdigitalkondensatoren, Elektroden, Temperatursensoren, Sensoren zur Messung eines Gasgehaltes, optische Sensoren und/oder andere chemische oder physikalische Sensoren umfassen.

Der Halbleiterchip 2 ist an einer Flachseite des Trägerteils 4 mit der aktiven Sensorfläche 5 dem Durchgangsloch 3 zugewandt angeordnet. Zwischen dem Trägerteil 4 und dem Halbleiterchip 2 ist ein Spalt gebildet, in welchem eine das Durchgangsloch 3 umgrenzende Dichtung angeordnet ist, die ein in das Durchgangsloch 3 einbringbares, mit den Sensoren 6 zu untersuchendes Medium gegen die der aktiven Sensorfläche 5 abgewandte Rückseite des Halbleiterchips 2 abdichtet.

Der Halbleiterchip 2 weist elektrische Leiterbahnen 8 auf, welche die Sensoren 6 mit in dem Spalt befindlichen, dem Trägerteil 4 zugewandten Anschlußstellen 9 verbinden. Die Anschlußstellen 9 sind jeweils mittels einer in dem Spalt angeordneten Flip-Chip-Verbindung 10 mit einem ihnen zugeordneten Anschlußkontakt 11 einer Leiterbahn 12 des Trägerteils 4 verbunden. Die Leiterbahnen 12 können beispielsweise zu einer Auswerteeinrichtung, einer Stromversorgungseinheit führen und/oder mit zu anderen Anschlußstellen 9 des Halbleiterchips 2 führenden Anschlußkontakten 11 verbunden sein.

Bei den Ausführungsbeispielen nach Fig. 2 und 4 weisen die Leiterbahnen 12 des Trägerteils 4 Kontaktelemente 13 auf, die mit Gegenkontakten 14 eines Leiterbahnen 15 aufweisenden Leiterbahnträgers 16 verbunden sind. Der Leiterbahnträger 15 ist an der die Kontaktelemente 13 aufweisenden Rückseite des Trägerteils 4 angeordnet, wobei die Gegenkontakte 14 den Kontaktelementen 13 des Trägerteils 4 zugewandt und mittels Flip-Chip-Verbindungen 17 elektrisch mit diesen verbunden sind. Die Anschlußstellen 9 des Halbleiterchips 2 sind also sowohl mittels der Leiterbahnen 12 des Trägerteils 4, als auch mittels der Leiterbahnen 15 des Leiterbahnträgers 16 untereinander und/oder mit den Anschlußstellen 9 weiterer Halbleiteranordnungen oder elektrischer Bauteile verbunden. Die Verdrahtung der Anschlußstellen 9 erfolgt somit in zwei Ebenen, wodurch die Dichte der Leiterbahnen reduziert wird. Die Meßeinrichtung 1 ermöglicht deshalb einen besonders kompakten Aufbau. Dabei ist es insbesondere möglich, an dem Leiterbahnträger 16 eine Vielzahl von jeweils einen Halbleiterchip 2 und ein damit verbundenes Trägerteil 4 aufweisenden Halbleiteranordnungen dicht benachbart nebeneinander anzuordnen. Die einerseits zwischen dem Halbleiterchip 2 und dem Trägerteil 4 und andererseits zwischen diesem und dem Leiterbahnträger 16 angeordneten Flip-Chip-Verbindungen 10, 17 ermöglichen darüber hinaus eine einfache Herstellung und Montage der Meßeinrichtung 1. Insbesondere läßt sich die Flip-Chip-Technologie gut in den Herstellungsprozeß des Halbleiterchips 2, des Trägerteils 4 und des Leiterbahnträgers 16 integrieren. Die Flip-Chip-Verbindungen 10, 17 können Bumps aufweisen, die gegebenenfalls mit den Leiterbahnen 8, 12, 16 fest verbunden sein können.

In dem Ausführungsbeispiel nach Fig. 2 und 4 weist der Leiterbahnträger an seiner dem Halbleiterchip 2 zugewandten Vorderseite eine Ausnehmung 18 auf, in welcher der Halbleiterchip 2 angeordnet ist. Im Bereich der Ausnehmung 18 hintergreift der Leiterbahnträger 16 die der aktiven Sensorfläche 5 abgewandte Rückseite des Halbleiterchips 2. In dem die Rückseite des Halbleiterchips 2 hintergreifenden Bereich des Leiterbahnträgers 16 können Leiterbahnen 15 angeordnet sein. Dadurch kann der an der Rückseite des Halbleiterchips 2 befindliche Raum für die Verdrahtung der Anschlußstellen 9 des Halbleiterchips 2 oder anderer elektrischer Bauteile der Meßeinrichtung 1 genutzt werden.

In dem Ausführungsbeispiel nach Fig. 1 und 2 ist als Dichtung 7 ein Dichtring vorgesehen, dessen dem Durchgangsloch 3 zugewandte Innenwandung aus einem porösen Material besteht, in dessen Poren ein biologischer Wirkstoff enthalten ist. Dieser wird bei einem Kontakt mit einer in das Durchgangsloch 3 eingefüllten Nährflüssigkeit mit darin enthaltenen, zu untersuchenden Biokomponenten freigesetzt wird, beispielsweise um die Biokomponenten über einen längeren Zeitraum zu ernähren.

Bei den Ausführungsbeispielen nach Fig. 3 und 4 ist die Dichtung 7 eine Membran, die durch eine in den zwischen dem Halbleiterchip 2 und dem Trägerteil 4 gebildeten Spalt eingefüllte Vergußmasse gebildet ist. Bei der Herstellung der Meßeinrichtung 1 wird der Halbleiterchip 2 so an dem Trägerteil 4 angeordnet, daß zwischen dem Halbleiterchip 2 und dem Trägerteil 4 ein Kapillarspalt gebildet ist, der vorzugsweise um das Durchgangsloch 3 umläuft. An dem dem Durchgangsloch abgewandten Außenrand des Spalts wird dann von der Rückseite des Trägerteils 4 her als Vergußmasse ein in einem Lösungsmittel gelöstes Membranmaterial in den Spalt eingefüllt. Dabei ist es sogar möglich, daß die Vergußmasse nur an einer Stelle des Außenumfangs des Spalts eingefüllt wird und sich dann durch die Kapillarwirkung in Erstreckungsrichtung des Spalts ringförmig um das Durchgangsloch 3 verteilt. In vorteilhafter Weise stoppt die Vergußmasse beim Einfüllen in den Spalt an dem dem Durchgangsloch 3 zugewandten Innenrand des Spalts durch die dort endende Kapillarwirkung. Dadurch wird eine Berührung der Vergußmasse mit der aktiven Sensorfläche 5 der Sensoren 6 und somit eine Beeinträchtigung der Funktion der Sensoren 6 vermieden. Die Vergußmasse bildet in dem Spalt eine Membran aus, die nur für bestimmte chemische Stoffe durchlässig ist und im übrigen das an der Vorderseite des Halbleiterchips befindliche Durchgangsloch gegen die Rückseite des Halbleiterchips abdichtet.

Wie aus Fig. 3 besonders gut erkennbar ist, weist das Trägerteil 4 im Bereich des Spalts einen über die Oberflächenebene der dem Halbleiterchip 2 zugewandten Oberfläche des Trägerteils 4 vorstehenden Vorsprung 19 auf, der an dem dem Durchgangsloch 3 zugewandten Innenwände der Dichtung 7 angeordnet ist und um das Durchgangsloch 3 umläuft. Im Bereich des Vorsprungs 19 ist die lichte Weite des zwischen dem Trägerteil 4 und dem Halbleiterchip 2 gebildeten Spalts reduziert. Dadurch wird auch beim Einfüllen einer dünnflüssigen Vergußmasse in den Spalt erreicht, daß die Vergußmasse an dem dem Durchgangsloch 3 zugewandten inneren Rand des Spalts durch die dort endende Kapillarwirkung stoppt. Dabei kann die Vergußmasse gegebenenfalls auch in den Spalt eingeschwemmt werden.

Der Vorsprung 19 weist im Querschnitt etwa die Form eines 1/4-Kreissektors auf und schließt an seiner dem Durchgangsloch 3 zugewandten Innenseite bündig an die Oberflächenebene der das Durchgangsloch 3 umgrenzenden Innenwand des Trägerteils 4 an. Ausgehend von dem äußeren zum inneren Rand des Spalts nimmt die lichte Weite des Spalts im Bereich des Vorsprungs 19 stetig ab.

Der Vorsprung 19 kann in das Trägerteil 4 eingeprägt sein. In Fig. 3 ist deutlich erkennbar, daß an der dem Vorsprung abgewandten Vorderseite des Trägerteils 4 eine zu dem Vorsprung komplementär ausgebildete Prägevertiefung 20 angeordnet ist.

Bei dem Ausführungsbeispiel nach Fig. 2 und 4 weist das Trägerteil an seiner dem Halbleiterchip 2 abgewandten Vorderseite eine Klebeschicht 21 auf, die mit der Unterseite eines eine Lochung 22 aufweisenden Behältnisses 23 verbunden. Dabei ist das Trägerteil 4 so an dem Behältnis 23 positioniert, daß die Lochung 22 des Behältnisses 23 mit dem Durchgangsloch 3 des Trägerteils 4 fluchtet. Wie aus Fig. 2 und 4 erkennbar ist, weist das Behältnis 23 unterseitig eine Aussparung auf, in die das Trägerteil 4 eingesetzt ist. Die Lochung 22 und das Durchgangsloch 3 bilden einen Aufnahmeraum für eine mit den Sensoren 6 zu untersuchende Probe. Das Behältnis 23 kann ein Mikrotiterplatten-Oberteil sein, das eine Vielzahl von Lochungen 22 aufweist, an denen jeweils eine einen Halbleiterchip 2 und ein Trägerteil 4 mit einem Durchgangsloch 3 aufweisende Halbleiteranordnung positioniert ist.

Erwähnt werden soll noch, daß die Leiterbahnen 8, 12, 15 auch aufgedruckt, aufgedampft oder als leitfähige Schicht ausgebildet sein können. Gegebenenfalls kann der Halbleiterchip 2, das Trägerteil 4 und/oder der Leiterbahnträger 16 in mehreren Lagen angoerdnete Leiterbahnen 8, 12, 15 aufweisen.

Das Trägerteil 4 kann eine lichtdurchlässige Schicht aufweisen oder insgesamt lichtdurchlässig sein. Außerdem kann das Trägerteil 4 ein chemisches Reservoir aufweisen.

Wenn es sich bei dem Sensor 6 beispielsweise um einen Hallsensor handelt, kann in dem Durchgangsloch 3 eine stabilisierende und Sensoroberflächen-schonenden Schutzschicht angeordnet sein. Um diese Anordnung herum kann dann in üblicher Weise noch eine mechanisch stabile Umgießschicht vorgesehen sein, die Quarzpartikel und dergleichen als Füllmaterial enthalten kann. Da diese Umgießschicht aber nicht mehr direkt mit der Sensoroberfläche in Berührung kommt, werden Beschädigungen durch das Füllmaterial vermieden.

## Patentansprüche

1. Meßeinrichtung (1) mit wenigstens einer Halbleiteranordnung, die einen eine Vorder- und eine Rückseite aufweisenden Halbleiterchip (2) und ein mit diesem verbundenes, zumindest ein Durchgangsloch (3) aufweisendes Trägerteil (4) umfaßt, wobei der Halbleiterchip (2) wenigstens einen Sensor (6) mit einer aktiven Sensorfläche (5) aufweist, die an der Vorderseite des Halbleiterchips (2) angeordnet und dem Durchgangsloch (3) zugewandt ist, wobei der Halbleiterchip (2) elektrische Anschlußstellen (9) hat, die mittels Flip-Chip-Verbindungen (10) mit an dem Trägerteil (4) befindlichen, den Anschlußstellen (9) zugewandten Anschlußkontakten (11) verbunden sind, wobei das Trägerteil (4) elektrische Leiterbahnen (12) aufweist, welche die Anschlußkontakte (11) mit aneiner Rückseite des Trägerteils (4) befindlichen Kontaktelementen (13) verbinden, wobei wenigstens ein Leiterbahnträger (16) vorgesehen ist, der mit den Kontaktelementen (13) verbundene, an Leiterbahnen (15) angeschlossene Gegenkontakte (14) aufweist, wobei zwischen dem Trägerteil (4) und dem Halbleiterchip (2) eine Dichtung (7) angeordnet ist, die das Durchgangsloch gegen die Rückseite des Halbleiterchips abdichtet, wobei der Halbleiterchip (2), die Dichtung (7) and das Trägerteil (4) eine Meßkammer begrenzen, **dadurch gekennzeichnet, daß** zumindest ein Teilbereich des Leiterbahnträgers (16) an der Rückseite des Trägerteils (4) mit den Gegenkontakten (14) den Kontaktelementen (13) des Trägerteils (4) zugewandt angeordnet ist, daß die Gegenkontakte (14) des Leiterbahnträgers (16) mit den ihnen jeweils zugeordneten Kontaktelementen (13) des Trägerteils (4) mittels Flip-Chip-Verbindungen (17) verbunden sind, und daß die Dichtung (7) zum Einbringen einer Substanz in die Meßkammer zumindest bereichsweise porös oder halbporös ausgebildet ist.

2. Meßeinrichtung (1) nach dem Oberbegriff von Anspruch 1, **dadurch gekennzeichnet, daß** zumindest ein Teilbereich des Leiterbahnträgers (16) an der Rückseite des Trägerteils (4) mit den Gegenkontakten (14) den Kontaktelementen (13) des Trägerteils (4) zugewandt angeordnet ist, daß die Gegenkontakte (14) des Leiterbahnträgers (16) mit den ihnen jeweils zugeordneten Kontaktelementen (1 3) des Trägerteils (4) mittels Flip-Chip-Verbindungen (17) verbunden sind, und daß die Dichtung (7) zum Einbringen einer Substanz in die Meßkammer als Membrane ausgebildet ist.

3. Meßeinrichtung(1) nach Anspruch 1 oder 2, **dadurch gekennzeichnet, daß** die Dichtung (7) durch eine in den zwischen dem Halbleiterchip (2) und dem Trägerteil (4) befindlichen Spalt eingefüllte Vergußmasse gebildet ist.

4. Meßeinrichtung (1) nach Anspruch einem der Ansprüche 1 bis 3, **dadurch gekennzeichnet, daß** die Dichtung (7) optisch transparent ist und/oder von mindestens einem Lichtleiter durchsetzt ist.

5. Meßeinrichtung (1) nach einem der Ansprüche 1 bis 4, **dadurch gekennzeichnet, daß** der Sensor (6) ein optischer, insbesondere bildgebender Sensor ist, und daß in dem Durchgangsloch (3) wenigstens eine optische Linse und/oder mindestens ein optischer Filter angeordnet ist.

6. Meßeinrichtung (1) nach einem der Ansprüche 1 bis 5, **dadurch gekennzeichnet, daß** das Trägerteil (4) eine Vielzahl von Durchgangslöchern (3) mit jeweils dort angeordnetem Halbleiterchip (2) aufweist.

7. Meßeinrichtung (1) nach Anspruch 6, **dadurch gekennzeichnet, daß** an den einzelnen Durchgangslöchern (3) unterschiedliche Halbleiterchips (2) angeordnet sind und daß diese insbesondere unterschiedliche Sensoren (6) auf weisen.

8. Meßeinrichtung (1) nach einem der Ansprüche 1 bis 7, **dadurch gekennzeichnet, daß** an der dem Halbleiterchip (2) abgewandten Seite des Trägerteils (4) an dem das Durchgangsloch (3) umgrenzenden Randbereich des Trägerteils (4) eine Auflage für ein Formwerkzeug zum Formen eines Behältnisses (23) angeordnet ist und daß auf den die Auflage umgrenzenden Bereich des Trägerteils (4) ein die Wandung des Behältnisses (23) bildender Kunststoff aufgespritzt ist.

9. Meßeinrichtung (1) nach einem der Ansprüche 1 bis 8, **dadurch gekennzeichnet, daß** sie als Mikrotiter-Meßeinrichtung mit einer Vielzahl von Halbleiteranordnungen ausgebildet ist.

10. Meßeinrichtung (1) nach einem der Ansprüche 1 bis 9, **dadurch gekennzeichnet, daß** das Trägerteil (4) an seiner dem Halbleiterchip (2) abgewandten Vorderseite insbesondere mittels einer Klebeschicht mit einem Mikrotiterplatten-Oberteil verbunden ist.

## Claims

1. Measuring device (1) having at least one semiconductor arrangement, which comprises a semiconductor chip (2) having a front side and a rear side and a carrier part (4) connected to said semiconductor chip and having at least one passage hole (3), the semiconductor chip (2) having at least one sensor (6) with an active sensor area (5) which is arranged on the front side of the semiconductor chip (2) and faces the passage hole (3), the semiconductor chip (2) having electrical connecting locations (9) which are connected by means of flip-chip connections (10) to connecting contacts (11) situated on the carrier part (4) and facing the connecting locations (9), the carrier part (4) having electrical conductor tracks (12) which connect the connecting contacts (11) to contact elements (13) situated on a rear side of the carrier part (4), at least one conductor-track carrier (16) being provided, which has mating contacts (14) connected to the contact elements (13) and connected to conductor tracks (15), a seal (7) being arranged between the carrier part (4) and the semiconductor chip (2) and sealing the passage hole with respect to the rear side of the semiconductor chip, the semiconductor chip (2), the seal (7) and the carrier part (4) delimiting a measuring chamber, **characterized in that** at least one partial region of the conductor-track carrier (16) is arranged on the rear side of the carrier part (4) with the mating contacts (14) facing the contact elements (13) of the carrier part (4), **in that** the mating contacts (14) of the conductor-track carrier (16) are connected to the contact elements (13) - respectively assigned to them - of the carrier part (4) by means of flip-chip connections (17), and **in that** the seal (7) is formed such that it is porous or semiporous at least in regions for the purpose of introducing a substance into the measuring chamber.

2. Measuring device (1) according to the preamble of Claim 1, **characterized in that** at least one partial region of the conductor-track carrier (16) is arranged on the rear side of the carrier part (4) with the mating contacts (14) facing the contact elements (13) of the carrier part (4), **in that** the mating contacts (14) of the conductor-track carrier (16) are connected to the contact elements (13) - respectively assigned to them - of the carrier part (4) by means of flip-chip connections (17), and **in that** the seal (7) is formed as a membrane for the purpose of introducing a substance into the measuring chamber.

3. Measuring device (1) according to Claim 1 or 2, **characterized in that** the seal (7) is formed by a potting composition filled into the gap situated between the semiconductor chip (2) and the carrier part (4).

4. Measuring device (1) according to one of Claims 1 to 3, **characterized in that** the seal (7) is optically transparent and/or is penetrated by at least one optical waveguide.

5. Measuring device (1) according to one of Claims 1 to 4, **characterized in that** the sensor (6) is an optical, in particular imaging, sensor, and **in that** at least one optical lens and/or at least one optical filter is arranged in the passage hole (3).

6. Measuring device (1) according to one of Claims 1 to 5, **characterized in that** the carrier part (4) has a multiplicity of passage holes (3) each with a semiconductor chip (2) arranged there.

7. Measuring device (1) according to Claim 6, **characterized in that** different semiconductor chips (2) are arranged at the individual passage holes (3), and **in that** said semiconductor chips have, in particular, different sensors (6).

8. Measuring device (1) according to one of Claims 1 to 7, **characterized in that** a support for a mould for moulding a container (23) is arranged on that side of the carrier part (4) which is remote from the semiconductor chip (2), on the edge region of the carrier part (4) that delimits the passage hole (3), and **in that** a plastic forming the wall of the container (23) is injected onto that region of the carrier part (4) which delimits the support.

9. Measuring device (1) according to one of Claims 1 to 8, **characterized in that** it is formed as a microtitre measuring device having a multiplicity of semiconductor arrangements.

10. Measuring device (1) according to one of Claims 1 to 9, **characterized in that** the carrier part (4), on its front side remote from the semiconductor chip (2), is connected to an upper part of a microtitre plate in particular by means of an adhesive layer.

## Revendications

1. Dispositif de mesure (1) avec au moins un dispositif semi-conducteur, qui comprend une puce à semi-conducteur (2) présentant une face avant et une face arrière et une pièce de support (4) assemblée à celle-ci et présentant au moins un trou de passage (3), dans lequel la puce à semi-conducteur (2) comprend au moins un détecteur (6) avec une face de détection active (5), qui est disposée sur la face avant de la puce à semi-conducteur (2) et qui est tournée vers le trou de passage (3), dans lequel la puce à semi-conducteur (2) comporte des points de raccordement électrique (9) qui sont raccordés, au moyen de raccordements de transistors planaires (10), à des contacts de raccordement (11) se trouvant sur la pièce de support (4) et tournés vers les points de raccordement (9), dans lequel la pièce de support (4) présente des voies conductrices électriques (12) qui relient les contacts de raccordement (11) à des éléments de contact (13) se trouvant sur une face arrière de la pièce de support (4), dans lequel il est prévu au moins un support de voies conductrices (16) qui présente des contacts opposés (14) raccordés à des voies conductrices (15) et reliés aux éléments de contact (13), dans lequel un joint d'étanchéité (7) est disposé entre la pièce de support (4) et la puce à semi-conducteur (2) et obture le trou de passage par rapport à la face arrière de la puce à semi-conducteur, dans lequel la puce à semi-conducteur (2), le joint d'étanchéité (7) et la pièce de support (4) délimitent une chambre de mesure, **caractérisé en ce qu'**au moins une région partielle du support de voies conductrices (16) est disposée sur la face arrière de la pièce de support (4) avec les contacts opposés (14) tournés vers les éléments de contact (13) de la pièce de support (4), **en ce que** les contacts opposés (14) du support de voies conductrices (16) sont raccordés, au moyen de raccordements de transistors planaires (17), aux éléments de contact (13) de la pièce de support (4) qui leur sont respectivement associés, et **en ce que** le joint d'étanchéité (7) est poreux ou semi-poreux, au moins par zones, pour introduire une substance dans la chambre de mesure.

2. Dispositif de mesure selon le préambule de la revendication 1, **caractérisé en ce qu'**au moins une région partielle du support de voies conductrices (16) est disposé sur la face arrière de la pièce de support (4) avec les contacts opposés (14) tournés vers les éléments de contact (13) de la pièce de support (4), **en ce que** les contacts opposés (14) du support de voies conductrices (16) sont raccordés, au moyen de raccordements de transistors planaires (17), aux éléments de contact (13) de la pièce de support (4) qui leur sont respectivement associés, et **en ce que** le joint d'étanchéité (7) est constitué par une membrane pour introduire une substance dans la chambre de mesure.

3. Dispositif de mesure (1) selon la revendication 1 ou 2, **caractérisé en ce que** le joint d'étanchéité (7) est formé par une masse de moulage coulée dans la fente se trouvant entre la puce à semi-conducteur (2) et la pièce de support (4).

4. Dispositif de mesure (1) selon l'une quelconque des revendications 1 à 3, **caractérisé en ce que** le joint d'étanchéité (7) est optiquement transparent et/ou est traversé par au moins un guide de lumière.

5. Dispositif de mesure (1) selon l'une quelconque des revendications 1 à 4, **caractérisé en ce que** le détecteur (6) est un détecteur optique, en particulier formant une image, et **en ce qu'**au moins une lentille optique et/ou au moins un filtre optique est disposé(e) dans le trou de passage (3).

6. Dispositif de mesure (1) selon l'une quelconque des revendications 1 à 5, **caractérisé en ce que** la pièce de support (4) comprend une pluralité de trous de passage (3) équipés chacun d'une puce à semi-conducteur (2).

7. Dispositif de mesure (1) selon la revendication 6, **caractérisé en ce que** des puces à semi-conducteur différentes (2) sont disposées dans les divers trous de passage (3) et **en ce que** celles-ci présentent en particulier des détecteurs différents (6).

8. Dispositif de mesure (1) selon l'une quelconque des revendications 1 à 7, **caractérisé en ce qu'**un appui pour un outil de formage pour le formage d'un réservoir (23) est disposé sur la face de la pièce de support (4) située à l'opposé de la puce à semi-conducteur (2), sur la région du bord de la pièce de support (4) entourant le trou de passage (3), et **en ce qu'**une matière plastique formant la paroi du réservoir (23) est projetée sur la région de la pièce de support (4) entourant l'appui.

9. Dispositif de mesure (1) selon l'une quelconque des revendications 1 à 8, **caractérisé en ce qu'**il est réalisé sous la forme d'un dispositif de mesure de microtitrage avec une pluralité de dispositifs semiconducteurs.

10. Dispositif de mesure (1) selon l'une quelconque des revendications 1 à 9, **caractérisé en ce que** la pièce de support (4) est assemblée, sur sa face avant située à l'opposé de la puce à semi-conducteur (2), à une partie supérieure d'une plaque de microtitrage, en particulier au moyen d'une couche de colle.
